# EUROPÄISCHE PATENTSCHRIFT

(11) **EP 3 484 690 B1**
(45) Veröffentlichungstag und Bekanntmachung des Hinweises auf die Patenterteilung: **23.08.2023**
(21) Anmeldenummer: 17733770.6
(22) Anmeldetag: 20.06.2017
(51) Int. Cl.: B29C 65/16, H05K 5/00, H05K 5/06, B29L 31/34

(54) **VERFAHREN ZUM AUSBILDEN EINER LASERSCHWEISSVERBINDUNG UND BAUTEILEVERBUND**
METHOD FOR FORMING A LASER-WELDED CONNECTION AND COMPOSITE COMPONENT
PROCÉDÉ POUR RÉALISER UNE LIAISON PAR SOUDAGE LASER ET ENSEMBLE COMPOSITE DE COMPOSANTS

(30) Priorität: 12.07.2016 DE 102016212690
(43) Veröffentlichungstag der Anmeldung: 22.05.2019
(73) Patentinhaber: Robert Bosch GmbH, 70442 Stuttgart (DE)
(72) Erfinder: FAISS, Markus, 72131 Ofterdingen (DE)
(86) Internationale Anmeldenummer: PCT/EP2017/065057
(87) Internationale Veröffentlichungsnummer: WO 2018/010919

(56) Entgegenhaltungen:
- EP-A2- 2 184 784
- WO-A1-2013/072439
- DE-A1-102014 211 438
- DE-A1-102014 211 443
- JP-A- 2000 233 450
- JP-A- 2001 232 687
- JP-A- 2014 220 384
- JP-A- 2015 160 334
- US-A1- 2005 094 937

## Beschreibung

### Stand der Technik

Die Erfindung betrifft ein Verfahren zum Ausbilden einer Laserschweißverbindung nach dem Oberbegriff des Anspruchs 1. Ferner betrifft die Erfindung einen Bauteileverbund, der nach einem erfindungsgemäßen Verfahren hergestellt ist.

Ein Verfahren zum Ausbilden einer Laserschweißverbindung nach dem Oberbegriff des Anspruchs 1 ist aus der DE 102 56 254 A1 bekannt. Das bekannte Verfahren findet bei der Fertigung von Steuergeräten Verwendung, bei dem eine Leiterplatte als ein von zwei Fügepartnern separates Bauteil durch Klemmschluss in einer von den beiden Fügepartnern ausgebildeten Aufnahme randseitig aufgenommen ist. Die Aufnahme ist im Bereich eines durch die beiden Fügepartner ausgebildeten Innenraums des Steuergeräts angeordnet, wobei die beiden Fügepartner im Bereich der Außenseite des Gehäuses miteinander verschweißt werden. Hierzu durchdringt ein Laserstrahl ein für die Laserstrahlung transparentes Material des einen Fügepartners bis in den Bereich eines Fügebereichs, in dem der Laserstrahl in Wirkverbindung mit dem für Laserstrahlung absorbierenden Material des anderen Fügepartners gelangt. Durch die Absorption der Laserstrahlung erwärmt sich das Material des zuletzt genannten Fügepartners bis über seinen Schmelzpunkt hinaus und schmelzt dabei auch das für die Laserstrahlung transparente Material des erstgenannten Fügepartners auf, um die Schweißverbindung auszubilden.

Das Ausbilden einer Aufnahme für das von den Fügepartnern separate Bauteil in Form einer Durchgangsöffnung, die es ermöglicht, das separate Bauteil bei einem Gehäuse durch eine Gehäusewand abgedichtet hindurchzuführen, wie dies beispielsweise für Kabeldurchführungen erforderlich ist, ist in der genannten Schrift nicht offenbart.

Aus dem Dokument WO 2013/072439 A1 ist ein Verfahren zum Ausbilden einer Laserschweißverbindung zwischen zwei Fügepartner über ein separates Bauteil für eine Medikamentendosierungsvorrichtung bekannt.

Aus dem Dokument EP 2 184 784 A2 ist ein Verfahren zum Ausbilden einer Laserschweißverbindung zwischen zwei Fügepartner für einen photoelektrischen Sensor bekannt.

### Offenbarung der Erfindung

Das Verfahren zum Ausbilden einer Laserschweißverbindung mit den Merkmalen des Anspruchs 1 hat den Vorteil, dass separate Bauteile, die als stromführende Bauteile ausgebildet sind, insbesondere in Form von stromführenden Kabeln oder ähnlichem, in eine zwischen den Fügepartnern ausgebildete Durchgangsöffnung angeordnet werden können, wobei der Bereich der Durchgangsöffnung nach dem Ausbilden der Schweißverbindung um das separate Bauteil herum dicht verschlossen ist, um beispielsweise bei Verwendung der Fügepartner zur Ausbildung eines Gehäuses den Eintritt von funktionsbeeinträchtigenden Medien in den Gehäuseinnenraum zu vermeiden.

Der Erfindung liegt die Idee zugrunde, dass das separate Bauteil eine Laserstrahlung absorbierende Umhüllung aufweist. Weiterhin wird das separate Bauteil im Bereich des für Laserstrahlung transparenten Fügepartners derart angeordnet, dass beim Einwirken der Laserstrahlung das für Laserstrahlung absorbierende Material des separaten Bauteils erwärmt wird und durch Wärmeübertrag von dem separaten Bauteil das Material des für Laserstrahlung transparenten Fügepartners aufgeschmolzen und dadurch die Durchgangsöffnung dicht verschlossen wird.

In einer bevorzugten Ausgestaltung des soweit beschriebenen erfindungsgemäßen Verfahrens ist es vorgesehen, dass sowohl das Material des für Laserstrahlung transparenten Fügepartners, als auch das für Laserstrahlung absorbierende Material des separaten Bauteils aufgeschmolzen wird und beim Aufschmelzen eine stoffschlüssige Verbindung ausbilden. Durch die stoffschlüssige Verbindung bzw. Vermengung der Materialien des zumindest einen Fügepartners und des separaten Bauteils wird eine besonders gute Abdichtung der Durchgangsöffnung ermöglicht.

Die Erfindung umfasst auch einen Bauteileverbund, der nach einem soweit beschriebenen erfindungsgemäßen Verfahren ausgebildet ist, wobei der Bauteileverbund sich dadurch auszeichnet, dass das separate Bauteil als stromführendes Bauteil ausgebildet ist und eine für Laserstrahlung absorbierende Umhüllung aufweist.

Vorteilhafte Weiterbildungen des Bauteileverbunds sind in den auf den Bauteileverbund rückbezogenen Unteransprüchen aufgeführt.

Insbesondere ist es vorgesehen, dass ein Bauteileverbund aus den beiden Fügepartnern ein Gehäuse eines Steuergeräts ausbildet, und dass das separate Bauteil der elektrischen Kontaktierung eines in dem Gehäuse angeordneten Elements dient. Bei dem elektrischen Element kann es sich beispielsweise um einen Schaltungsträger oder um einen sonstigen elektrischen Verbraucher handeln. Ein derartiger Bauteileverbund ermöglicht es, auf einen üblicherweise bei einem Gehäuse vorhandenen Anschlussstecker verzichten zu können, der mit einem externen Gegenstecker zur elektrischen Kontaktierung eines Steuergeräts verbunden werden muss. Ein derartiger Bauteileverbund hat daher den Vorteil, dass die Herstellkosten verringert werden können, und dass darüber hinaus eine besondere hohe Zuverlässigkeit der elektrischen Kontaktierung ermöglicht wird, da die üblicherweise vorhandene Steckverbindung im Gehäusebereich nicht vorgesehen sein muss.

Im einfachsten Fall ist das separate Bauteil in Form eines Stromkabels ausgebildet, wobei unter einem Stromkabel alle elektrischen Verbindungen verstanden werden sollen, die zur elektrischen Kontaktierung und/oder Stromversorgung geeignet sind. Die Form eines derartigen Stromkabels soll darüber hinaus nicht auf im Querschnitt rundes Stromkabel mit einer einzigen Leitung bzw. Litze beschränkt sein, vielmehr können auch Flachkabel mit mehreren stromführenden Leitungen bzw. Litzen vorgesehen sein.

Alternativ ist es auch denkbar, dass das separate Bauteil als Steckeranschlusselement ausgebildet ist. In diesem Fall findet eine Verschweißung oder zumindest eine Fixierung des Steckeranschlusselements im Bereich der Aufnahme zwischen den beiden Fügepartnern statt, wobei das Steckeranschlusselement dazu ausgebildet ist, mit einem entsprechenden Gegenstecker verbunden zu werden. Diese Lösung hat den Vorteil, dass zum Beispiel auf separate Dichtelemente wie Gummidichtungen o.ä. verzichtet werden kann, da eine unmittelbare dichte Verschweißung zwischen dem Anschlußstecker bzw. dem mit dem Anschlußstecker verbundenen Kabel (separates Bauteil) und den Fügepartnern bzw. dem Gehäuse erfolgt.

Hierzu kann es bei der Verwendung eines Steckeranschlusselements vorgesehen sein, dass die beiden Fügepartner im Bereich des Steckeranschlusselements einen Freiraum ausbilden, der dazu dient, den Gegenstecker formschlüssig mit dem Steckeranschlusselement verbinden zu können. Die Aufnahme ist in diesem Fall im Bereich der beiden Fügepartner derart ausgebildet, dass im Bereich der Durchgangsöffnung ein Freiraum verbleibt, der der formschlüssigen Anordnung des Gegensteckers dient.

Wesentlich bei der Ausbildung des Bauteileverbunds ist es, dass beim Einwirken der Laserstrahlung ein Wärmeübertrag von dem für Laserstrahlung absorbierenden Material des separaten Bauteils auf das Material des für Laserstrahlung transparenten Fügepartners erfolgt. Hierzu ist es vorteilhaft, wenn die Durchgangsöffnung und/oder das separate Bauteil der Durchgangsöffnung einen Querschnitt aufweisen/aufweist, der im Montagezustand des separaten Bauteils in der Durchgangsöffnung einen Anlagekontakt zwischen der Durchgangsöffnung und dem separaten Bauteil ausbildet, damit ein guter Wärmeübertrag von dem separaten Bauteil auf den/die Fügepartner erfolgt.

Bevorzugt ist die Ausbildung der Durchgangsöffnung in Form einer nutartigen Vertiefung in demjenigen Fügepartner, dessen Material für die Laserstrahlung transparent ist. Eine derartige nutartige Vertiefung hat den Vorteil, dass das separate Bauteil besonders einfach und genau gefügt und positioniert werden kann. Eine Weiterbildung des soweit beschriebenen Bauteileverbunds sieht vor, dass der für die Laserstrahlung absorbierende Fügepartner einen Fortsatz aufweist, der in die nutartige Vertiefung hineinragt. Insbesondere kann dieser Fortsatz auf der dem separaten Bauteil zugewandten Seite eine dem separaten Bauteil angepasste Form aufweisen. Dadurch wird die Abdichtung auf der dem separaten Bauteil abgewandten Seite des für die Laserstrahlung transparenten Fügepartners optimiert.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: eine Vorderansicht auf die Bestandteile eines Bauteileverbunds zur Ausbildung einer Kabeldurchführung an einem Gehäuse,
- Fig. 2: den Bauteileverbund gemäß Fig. 1 in einem Querschnitt während der Ausbildung der Verbindung zwischen den Fügepartnern,
- Fig. 3: einen Schnitt im Bereich der Kabeldurchführung zwischen zwei Fügepartnern nach dem Ausbilden der Schweißverbindung bei einem gegenüber den Fig. 1 und 2 modifizierten Bauteileverbund und
- Fig. 4: eine vereinfachte Darstellung einer Durchführung zwischen zwei Gehäuseteilen zur Ausbildung einer dichten Steckverbindung an einem Gehäuse.

Gleiche Elemente bzw. Elemente mit gleicher Funktion sind in den Figuren mit den gleichen Bezugsziffern versehen.

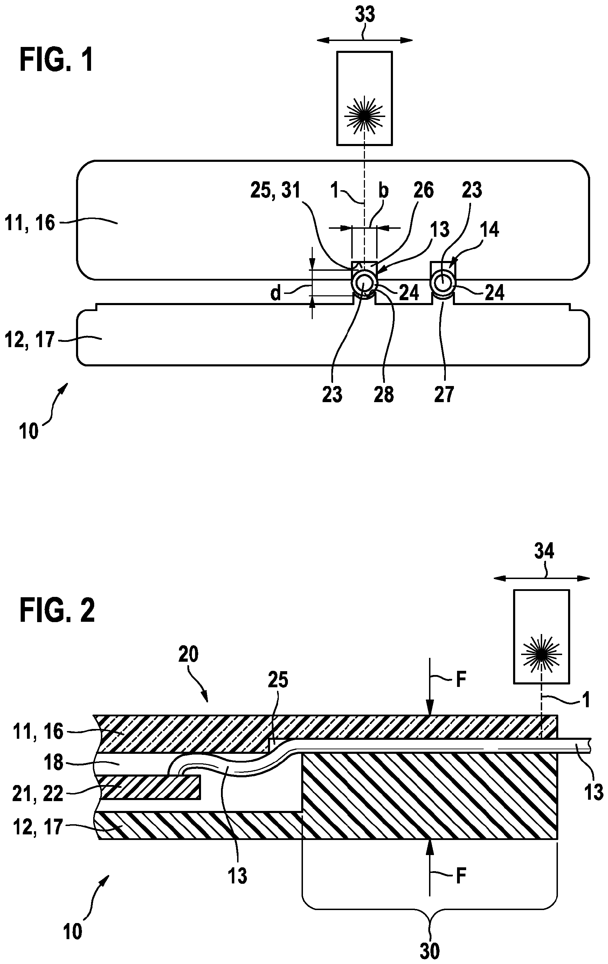

In den Fig. 1 und 2 ist ein Bauteileverbund 10 dargestellt, der aus einem ersten Fügepartner 11, einem zweiten Fügepartner 12 sowie zwei von den beiden Fügepartnern 11, 12 separaten, der Stromführung dienenden Kabeln 13, 14 besteht. Beispielhaft ist der erste Fügepartner 11 in Form eines Gehäusedeckels 16 ausgebildet, während der zweite Fügepartner 12 Bestandteil eines topfartigen Gehäuseteils 17 ist, so dass von den beiden Fügepartnern 11, 12 bzw. dem Gehäusedeckel 16 und dem Gehäusebauteil 17 nach dem (dichten) Verbinden der beiden Fügepartner 11, 12 ein einen Innenraum 18 ausbildendes Gehäuse 20 gebildet wird. In dem Innenraum 18 des Gehäuses 20 ist ein elektrischer Verbraucher 21, beispielsweise in Form einer eine elektrische Schaltung aufweisenden Leiterplatte 22 oder ähnlichem, angeordnet. Die beiden Kabel 13, 14 dienen der Stromversorgung bzw. elektrischen Kontaktierung des elektrischen Verbrauchers 21 im Gehäuse 20 und ermöglichen somit eine Kontaktierung des elektrischen Verbrauchers 21 von außen in den Innenraum 18 des Gehäuses 20.

Die beiden beispielhaft denselben Durchmesser aufweisenden Kabel 13, 14 weisen jeweils einen runden Kern in Form eines elektrischen Leiters 23, beispielsweise in Form einer Kupferlitze auf, der von einer Umhüllung 24 umgeben ist. Beispielhaft und nicht einschränkend, besteht die Umhüllung 24 aus PP (Polypropylen), PA (Polyamid), ABS (Acrylnitril-Butadien-StyrolCopolymerisat) und bedingt PBT (Polybutylenterephthalat). Wesentlich ist, dass das Material der Umhüllung 24 aus einem für Laserstrahlung absorbierenden Material besteht, d.h., dass bei der Einwirkung von Laserstrahlung sich das Material der Umhüllung 24 erwärmt bzw. aufgeschmolzen wird. Weiterhin besteht das Material des ersten Fügepartners 11 (Gehäusedeckel 16) aus einem für Laserstrahlung transparenten Material, während das Material des zweiten Fügepartners 12 (Gehäusebauteil 17), wie die Umhüllung 24 der Kabel 13, 14, aus einem für Laserstrahlung absorbierenden Material besteht. Insbesondere bestehen die beiden Fügepartner 11, 12 aus Kunststoff.

Wesentlich bei der Auswahl der verwendeten Materialien der beiden Fügepartner 11, 12 sowie der Umhüllung 24 der Kabel 13, 14 ist es auch, dass die aufgeschmolzenen Materialien sich vorzugsweise miteinander vermischen können, d.h. dass sie nach dem Erstarren eine stoffschlüssige und somit dichte Verbindung ausbilden.

Der erste Fügepartner 11 weist auf der dem zweiten Fügepartner 12 zugewandten Seite im Bereich einer Trennebene zwischen den beiden Fügepartnern 11, 12 eine einen rechteckigen Querschnitt aufweisende Vertiefung 25 in Form einer Nut auf, die der Ausbildung einer Durchgangsöffnung 26 dient. Innerhalb der Durchgangsöffnung 26 ist das jeweilige Kabel 13, 14 angeordnet, wobei der Querschnitt bzw. Durchmesser des Kabels 13, 14 derart an den Querschnitt der Vertiefung 25 angepasst ist, dass die Nutbreite b der Vertiefung 25 vorzugsweise gleich groß oder etwas geringer ist als der Durchmesser d des Kabels 13, 14, so dass eine Anlage der (zumindest geringfügig elastischen bzw. verformbaren) Umhüllung 24 im Bereich der Vertiefung 25 ermöglicht wird. Weiterhin weist der zweite Fügepartner 12 in Ausrichtung mit der Vertiefung 25 eine stegartige Erhebung 27 auf, die auf der dem Kabel 13, 14 zugewandten Seite eine konkave Anlagefläche 28 aufweist, die der Form des Kabels 13, 14 bzw. der Umhüllung 24 angepasst ist.

Bei der Montage der beiden Fügepartner 11, 12 sowie der Kabel 13, 14 werden die Fügepartner 11, 12 mit in der Fig. 2 erkennbaren Fügekräften F beaufschlagt, sodass die beiden Fügepartner 11, 12 in einem Fügebereich 30 in Anlagekontakt zueinander angeordnet sind. Dabei sind die beiden Kabel 13, 14 im Bereich der Vertiefung 25 aufgenommen und liegen einerseits am Grund 31 der Vertiefung 25 des ersten Fügepartners 11 und andererseits im Bereich der Anlagefläche 28 der Erhebung 27 des anderen Fügepartners 12 an.

Zum Ausbilden einer Verbindung zwischen den beiden Fügepartnern 11, 12 sowie zur Abdichtung der Durchgangsöffnung 26 im Bereich der Kabel 13, 14 wird ein Laserstrahl 1 vorzugsweise entlang der Außenkontur der beiden Fügepartnern 11, 12 geführt. Hierbei ist die Ausrichtung des Laserstrahls 1 zu den Fügepartnern 11, 12 derart, dass der Laserstrahl 1 auf der dem zweiten Fügepartner 12 abgewandten Seite des ersten Fügepartners 11 in den ersten Fügepartner 11 eintritt. Dadurch, dass der erste Fügepartner 11 aus einem für Laserstrahlung transparenten Material besteht, gelangt der Laserstrahl 1 bis in den Fügebereich 30, wo er auf das Material des für Laserstrahlung absorbierenden zweiten Fügepartners 12 trifft. In dem Fügebereich 30 bewirkt der Laserstrahl 1 eine Erwärmung und ein Aufschmelzen des Materials des zweiten Fügepartners 12, wobei durch den Anlagekontakt zum ersten Fügepartner 11 auch ein Wärmeübergang auf den ersten Fügepartner 11 auftritt, der dadurch ebenfalls aufgeschmolzen wird.

Nach dem Aufschmelzen der Materialen der beiden Fügepartner 11, 12 und anschließendem Erstarren der Materialen ist zwischen den beiden Fügepartnern 11, 12 eine Laserschweißnaht ausgebildet. Entsprechend der Darstellung der Fig. 2 wird der Laserstrahl 1 auch über den Bereich der beiden Durchgangsöffnungen 26 mit den darin befindlichen Kabeln 13, 14 geführt. Dabei wird das Laserstrahlung absorbierende Material der Umhüllung 24 ebenfalls aufgeschmolzen, da der Laserstrahl 1 im Bereich des Grunds 31 der Vertiefung 25 in das Material der Umhüllung 24 eintritt. Durch Wärmeübertrag des erwärmten Materials der Umhüllung 24 findet auf der der Erhebung 27 abgewandten Seite des Kabels 13, 14 ebenfalls ein Aufschmelzen des Materials des ersten Fügepartners 11 statt. Ebenso wird der seitliche Bereich der Vertiefung 25 durch Anlagekontakt ebenso durch das Material der Umhüllung 24 aufgeschmolzen, ebenso wie der Bereich der Anlagefläche 28 im Bereich der Erhebung 27.

Obwohl es prinzipiell genügt, wenn der Laserstrahl 1 den Bereich der Vertiefung 25 entsprechend des Pfeils 33 (Fig. 1) senkrecht zu dessen Längserstreckung durchquert, sodass an einer einzigen Stelle der Längserstreckung der Vertiefung 25 ein Aufschmelzen des Materials der beiden Fügepartnern 11, 12 sowie der Umhüllung 24 erfolgt, ist es bevorzugt vorgesehen, dass der Laserstrahl 1 entsprechend der Darstellung der Fig. 2 zusätzlich entlang der Erstreckung der Vertiefung 25 in Richtung des Pfeils 34 bewegt wird, um über die gesamte Länge der Vertiefung 25 ein Aufschmelzen der Umhüllung 24 und somit das Ausbilden einer dichten Verbindung zu ermöglichen.

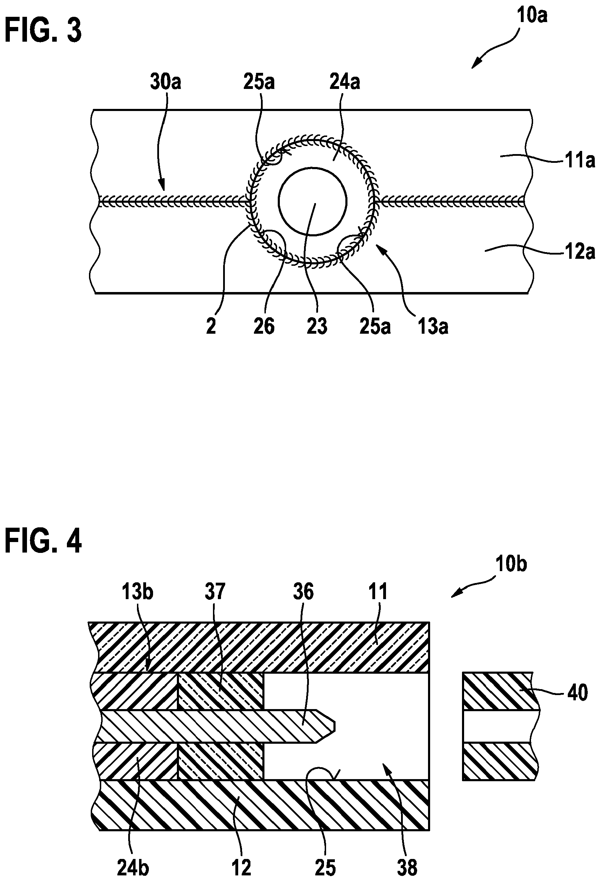

In der Fig. 3 ist ein Bauteileverbund 10a zwischen zwei Fügepartnern 11a, 12a gezeigt, die beide im Bereich der Durchgangsöffnung 26 eine im Querschnitt halbkreisförmige Vertiefung 25a aufweisen. Das mittig und in Anlagekontakt zu den beiden Vertiefungen 25a angeordnete Kabel 13a weist eine um die Umhüllung 24a kreisförmig umlaufende Schweißnaht 2 auf, die sich beidseitig der Vertiefung 25a im Fügebereich 30a der beiden Fügepartner 11a, 12a fortsetzt.

In der Fig. 4 ist ein Ausführungsbeispiel mit einem Bauteileverbund 10b dargestellt, bei dem ein Kabel 13b im Bereich der Vertiefung 25 auf der dem Innenraum 18 abgewandten Seite einen stiftartigen Kontakt 36 in einem als separatem Bauteil ausgebildeten Anschlußkörper 37 ausbildet, wobei der Anschlußkörper 37 zumindest im Bereich des Kontakts 36 aus einem für Laserstrahlung transparenten Material besteht. An den Anschlußkörper 37 schließt sich in Richtung des Innenraums 18 die Umhüllung 24b des Kabels 13b an, die für Laserstrahlung absorbierend ist. Da der Kontakt 36 im Bereich der Vertiefung 25 angeordnet ist und durch den Anschlußkörper 37 positioniert wird sowie frei in die Vertiefung 25 hineinragt, bildet die Vertiefung 25 eine Aufnahme 38 für einen lediglich vereinfacht dargestellten Gegenstecker 40 aus, der der elektrischen Kontaktierung des Kabels 13a dient, und der formschlüssig in die Vertiefung 25 bzw. die Durchgangöffnung 26 eingeführt werden kann, um mit dem Kontakt 36 elektrisch leitend verbunden zu werden.

Der soweit beschriebene Bauteileverbund 10, 10a, 10b sowie das Verfahren zum Ausbilden der Verbindung zwischen den Fügepartnern 11, 11a, 12, 12a und den Kabeln 13, 13a, 13b und 14 können in vielfältiger Art und Weise abgewandelt bzw. modifiziert werden, ohne vom Erfindungsgedanken abzuweichen. Ferner soll die Erfindung nicht auf die Verwendung von stromführenden separaten Bauteilen beschränkt sein, die im Bereich einer Durchgangsöffnung 26 zwischen den beiden Fügepartnern 11, 11a 12, 12a angeordnet sind. Vielmehr ist es auch denkbar, dass beliebige andere Bauteile bzw. Elemente im Bereich einer Durchgangsöffnung 26 zwischen zwei Fügepartnern 11, 11a, 12, 12a hindurchgeführt werden können. Wesentlich ist lediglich, dass das Material eines im Bereich einer Durchgangsöffnung 26 befindlichen, von den beiden Fügepartnern 11, 11a, 12, 12a separaten Elements für Laserstrahlung absorbierend ausgebildet ist und in Wirkverbindung bzw. Anlagekontakt mit dem für Laserstrahlung transparenten einen der beiden Fügepartner 11, 11a, 12, 12a angeordnet wird.

## Patentansprüche

1. Verfahren zum Ausbilden einer Laserschweißverbindung, bei dem zwei Fügepartner (11; 11a, 12; 12a) durch Einwirkung eines Laserstrahls (1) in einem Fügebereich (30; 30a) unter Ausbildung einer Schweißnaht (2) miteinander verbunden werden, wobei der eine Fügepartner (11; 11a) aus einem für Laserstrahlung transparenten Material und der andere Fügepartner (12; 12a) aus einem für Laserstrahlung absorbierenden Material besteht, und wobei von den zwei Fügepartnern (11; 11a, 12; 12a) eine Aufnahme (25; 25a; 25b) für ein von den Fügepartnern (11; 11a, 12; 12a) separates Bauteil (13; 13a; 13b; 14) ausgebildet wird,
**dadurch gekennzeichnet,**
**dass** die Aufnahme (25; 25a; 25b) als Durchgangsöffnung (26) ausgebildet ist, dass das separate Bauteil (13; 13a; 13b; 14), das als stromführendes Bauteil ausgebildet ist und eine Laserstrahlung absorbierende Umhüllung (24; 24a; 24b) aufweist, zumindest teilweise aus einem für Laserstrahlung absorbierenden Material besteht, dass das für Laserstrahlung absorbierende Material des separaten Bauteils (13; 13a; 13b; 14) in Wirkverbindung mit dem Fügepartner (11; 11a) angeordnet wird, der aus dem für Laserstrahlung transparenten Material besteht, und dass der Laserstrahl (1) auf das für Laserstrahlung absorbierende Material des separaten Bauteils (13; 13a; 13b; 14) einwirkt, so dass durch Wärmeübertrag von dem separaten Bauteil (13; 13a; 13b; 14) das für Laserstrahlung transparente Material des einen Fügepartners (11; 11a) aufgeschmolzen und die Durchgangsöffnung (26) verschließt.

2. Verfahren nach Anspruch 1,
**dadurch gekennzeichnet,**
**dass** das die Laserstrahlung absorbierende Material des separaten Bauteils (13; 13a; 13b; 14) aufgeschmolzen wird und zusammen mit dem Material des für Laserstrahlung transparenten Bauteils (11; 11a) eine stoffschlüssige Verbindung ausbildet.

3. Verfahren nach Anspruch 1 oder 2,
**dadurch gekennzeichnet,**
**dass** der Laserstrahl (1) quer und längs zur Erstreckung der Durchgangsöffnung (26) bewegt wird.

4. Bauteileverbund (10; 10a; 10b), hergestellt nach einem Verfahren nach einem der Ansprüche 1 bis 3,
**dadurch gekennzeichnet,**
**dass** das separate Bauteil (13; 13a; 13b; 14) als stromführendes Bauteil ausgebildet ist und eine Laserstrahlung absorbierende Umhüllung (24; 24a; 24b) aufweist.

5. Bauteileverbund nach Anspruch 4,
**dadurch gekennzeichnet,**
**dass** die beiden Fügepartner (11; 11a, 12; 12a) Bestandteil eines Gehäuses (20) sind, und dass das separate Bauteil (13; 13a; 13b; 14) der elektrischen Kontaktierung eines in dem Gehäuse (20) angeordneten Elements (21) dient.

6. Bauteileverbund nach Anspruch 4 oder 5,
**dadurch gekennzeichnet,**
**dass** das separate Bauteil (13; 13a; 13b; 14) ein Stromkabel ist.

7. Bauteileverbund nach Anspruch 4 oder 5,
**dadurch gekennzeichnet,**
**dass** das separate Bauteil (13b) innerhalb der Aufnahme (25) mit einem für Laserstrahlung transparentem Anschlußkörper (37) verbunden ist.

8. Bauteileverbund nach Anspruch 7,
**dadurch gekennzeichnet,**
**dass** die Durchgangsöffnung (26) im Bereich des Anschlußkörpers (37) auf der dem separaten Bauteil (13b) abgewandten einen von Material der Fügepartner (11, 12) freien Raum zur Aufnahme eines Gegensteckers (40) ausbildet.

9. Bauteileverbund nach einem der Ansprüche 4 bis 8,
**dadurch gekennzeichnet,**
**dass** die Durchgangsöffnung (26) und/oder das separate Bauteil (13; 13a; 13b; 14) im Bereich der Durchgangsöffnung (26) einen Querschnitt aufweisen/aufweist, der im Montagezustand des separaten Bauteils (13; 13a; 13b; 14) in der Durchgangsöffnung (26) vor der Einwirkung des Laserstrahls (1) einen Anlagekontakt zwischen der Durchgangsöffnung (26) und dem separaten Bauteil (13; 13a; 13b; 14) ausbildet.

10. Bauteileverbund nach einem der Ansprüche 4 bis 9,
**dadurch gekennzeichnet,**
**dass** die Durchgangsöffnung (26) eine nutartige Vertiefung in wenigstens dem Fügepartner (11) ausgebildet ist, dessen Material für die Laserstrahlung transparent ist.

11. Bauteileverbund nach Anspruch 10,
**dadurch gekennzeichnet,**
**dass** der für die Laserstrahlung absorbierende Fügepartner (12) eine Erhebung (27) aufweist, die in die nutartige Vertiefung hineinragt und an dem separaten Bauteil (13, 14) anliegt.

12. Bauteileverbund nach einem der Ansprüche 4 bis 11,
**dadurch gekennzeichnet,**
**dass** die Durchgangsöffnung (26) im Fügebereich (30; 30a) zwischen den beiden Fügepartnern (11; 11a, 12; 12a) angeordnet ist.

## Claims

1. Method for forming a laser-welded connection, in which two joining partners (11; 11a, 12; 12a) are connected to each other by action of a laser beam (1) in a joining region (30; 30a), forming a weld seam (2), wherein the one joining partner (11; 11a) consists of a material which is transparent to laser radiation and the other joining partner (12; 12a) consists of a material which is absorbent to laser radiation, and wherein a receptacle (25; 25a; 25b) for a component (13; 13a; 13b; 14) which is separate from the joining partners (11; 11a, 12; 12a) is formed by the two joining partners (11; 11a, 12; 12a),
**characterized in that**
the receptacle (25; 25a; 25b) is designed as a through-opening (26), **in that** the separate component (13; 13a; 13b; 14), which is designed as a current-conducting component and has a sheath (24; 24a; 24b) which is absorbent to laser radiation, consists at least partially of a material which is absorbent to laser radiation, **in that** the material of the separate component (13; 13a; 13b; 14), which material is absorbent to laser radiation, is arranged in a functionally communicating manner with the joining partner (11; 11a) which consists of the material which is transparent to laser radiation, and **in that** the laser beam (1) acts upon the material of the separate component (13; 13a; 13b; 14), which material is absorbent to laser radiation, so that by means of heat transfer from the separate component (13; 13a; 13b; 14) the material of the one joining partner (11; 11a), which material is transparent to laser radiation, is melted and closes off the through-opening (26).

2. Method according to Claim 1,
**characterized in that**
the material of the separate component (13; 13a; 13b; 14), which material is absorbent to laser radiation, is melted and together with the material of the component (11; 11a) which is transparent to laser radiation forms a materially-bonded connection.

3. Method according to Claim 1 or 2,
**characterized in that**
the laser beam (1) is moved across and along the extent of the through-opening (26).

4. Composite component (10; 10a; 10b) which is produced according to a method according to one of Claims 1 to 3,
**characterized in that**
the separate component (13; 13a; 13b; 14) is designed as a current-conducting component and has a sheath (24; 24a; 24b) which absorbs laser radiation.

5. Composite component according to Claim 4,
**characterized in that**
the two joining partners (11; 11a; 12; 12a) are component part of a housing (20), and **in that** the separate component (13; 13a; 13b; 14) serves for the electrical contacting of an element (21) which is arranged in the housing (20).

6. Composite component according to Claim 4 or 5,
**characterized in that**
the separate component (13; 13a; 13b; 14) is a power cable.

7. Composite component according to Claim 4 or 5,
**characterized in that**
the separate component (13b) inside the receptacle (25) is connected to an adjoining body (37) which is transparent to laser radiation.

8. Composite component according to Claim 7,
**characterized in that**
the through-opening (26), in the region of the adjoining body (37) on the facing away from the separate component (13b), forms a space which is free from material of the joining partner (11, 12) for accommodating a mating connector (40).

9. Composite component according to one of Claims 4 to 8,
**characterized in that**
the through-opening (26) and/or the separate component (13; 13a; 13b; 14) in the region of the through-opening (26) have/has a cross section which in the installed state of the separate component (13; 13a; 13b; 14) in the through-opening (26) before the action of the laser beam (1) forms an abutting contact between the through-opening (26) and the separate component (13; 13a; 13b; 14).

10. Composite component according to one of Claims 4 to 9,
**characterized in that**
the through-opening (26) is a groove-like recess which is formed in at least the joining partner (11), the material of which is transparent to laser radiation.

11. Composite component according to Claim 10,
**characterized in that**
the joining partner (12) which is absorbent to laser radiation has a raised portion (27) which projects into the groove-like recess and butts against the separate component (13, 14).

12. Composite component according to one of Claims 4 to 11,
**characterized in that**
the through-opening (26) is arranged in the joining region (30; 30a) between the two joining partners (11; 11a, 12; 12a).

## Revendications

1. Procédé de formation d'une liaison par soudage au laser, dans lequel deux pièces à assembler (11 ; 11a, 12 ; 12a) sont reliées l'une à l'autre par l'action d'un faisceau laser (1) dans une zone d'assemblage (30 ; 30a) pour former un cordon de soudure (2), l'une des pièces à assembler (11 ; 11a) étant en une matière qui est transparente au rayonnement laser et l'autre pièce à assembler (12; 12a) étant en une matière qui absorbe le rayonnement laser, et les deux pièces à assembler (11 ; 11a, 12 ; 12a) formant un réceptacle (25 ; 25a ; 25b) destiné à un composant (13 ; 13a ; 13b ; 14) séparé des pièces à assembler (11 ; 11a, 12 ; 12a),
**caractérisé en ce que**
le réceptacle (25 ; 25a ; 25b) est conçu comme une ouverture de passage (26),
le composant séparé (13 ; 13a ; 13b ; 14) qui est conçu comme un composant conducteur de courant et qui comporte un enrobage absorbant le rayonnement laser (24 ; 24a ; 24b) est au moins partiellement en une matière qui absorbe le rayonnement laser,
la matière du composant séparé (13 ; 13a ; 13b ; 14) qui absorbe le rayonnement laser est disposée en liaison fonctionnelle avec la pièce à assembler (11 ; 11a) qui est en la matière transparente au rayonnement laser, et
le faisceau laser (1) agit sur la matière absorbant le rayonnement laser du composant séparé (13 ; 13a ; 13b ; 14) de sorte que la matière transparente au rayonnement laser d'une pièce à assembler (11 ; 11a) est fondue, et l'ouverture de passage (26) est fermée, par transfert de chaleur depuis le composant séparé (13 ; 13a ; 13b ; 14) .

2. Procédé selon la revendication 1,
**caractérisé en ce que**
la matière du composant séparé (13 ; 13a ; 13b ; 14) qui absorbe le rayonnement laser est fondue et forme une liaison de matière avec la matière du composant (11 ; 11a) qui est transparente au rayonnement laser.

3. Procédé selon la revendication 1 ou 2,
**caractérisé en ce que**
le faisceau laser (1) est déplacé transversalement et longitudinalement à l'extension de l'ouverture de passage (26).

4. Composite de composants (10 ; 10a ; 10b), réalisé par un procédé selon l'une des revendications 1 à 3,
**caractérisé en ce que**
le composant séparé (13 ; 13a ; 13b ; 14) est réalisé sous la forme d'un composant conducteur de courant et comporte un enrobage (24 ; 24a ; 24b) absorbant le rayonnement laser.

5. Composite de composants selon la revendication 4,
**caractérisé en ce que**
les deux pièces à assembler (11 ; 11a, 12 ; 12a) font partie d'un boîtier (20), et
le composant séparé (13 ; 13a ; 13b ; 14) sert à la mise en contact électrique d'un élément (21) disposé dans le boîtier (20) .

6. Composite de composants selon la revendication 4 ou 5,
**caractérisé en ce que**
le composant séparé (13 ; 13a ; 13b ; 14) est un câble d'alimentation.

7. Composite de composants selon la revendication 4 ou 5,
**caractérisé en ce que**
le composant séparé (13b) est relié à l'intérieur du réceptacle (25) à un corps de raccordement (37) qui est transparent au rayonnement laser.

8. Composite de composants selon la revendication 7,
**caractérisé en ce que**
l'ouverture de passage (26) forme dans la zone du corps de raccordement (37) un espace qui est dépourvu de matière des pièces à assembler (11, 12) sur l'opposé au composant séparé (13b) et qui est destiné à recevoir un connecteur homologue (40).

9. Composite de composants selon l'une des revendications 4 à 8,
**caractérisé en ce que**
l'ouverture de passage (26) et/ou le composant séparé (13 ; 13a ; 13b ; 14) présente/présentent dans la zone de l'ouverture de passage (26) une section transversale qui, lorsque le composant séparé (13 ; 13a ; 13b ; 14) est assemblé, forme un contact d'appui entre l'ouverture de passage (26) et le composant séparé (13 ; 13a ; 13b ; 14) dans l'ouverture de passage (26) avant l'action du faisceau laser (1).

10. Composite de composants selon l'une des revendications 4 à 9,
**caractérisé en ce que**
l'ouverture de passage (26) est une dépression en forme de rainure ménagée au moins dans la pièce à assembler (11) dont la matière est transparente au rayonnement laser.

11. Composite de composants selon la revendication 10,
**caractérisé en ce que**
la pièce à assembler (12) qui absorbe le rayonnement laser comporte une saillie (27) qui fait saillie dans la dépression en forme de rainure et qui vient en appui sur le composant séparé (13, 14).

12. Composite de composants selon l'une des revendications 4 à 11,
**caractérisé en ce que**
l'ouverture de passage (26) est ménagée entre les deux pièces à assembler (11 ; 11a, 12 ; 12a) dans la zone d'assemblage (30 ; 30 a) .
